# EUROPEAN PATENT APPLICATION

(11) **EP 4 550 988 A1**
(43) Date of publication of application: **07.05.2025**
(21) Application number: 24185286.2
(22) Date of filing: 28.06.2024
(51) Int. Cl.: H10K 59/131, H10K 59/82

(54) **DISPLAY APPARATUS**

(30) Priority: 02.11.2023 KR 20230150296
(71) Applicant: Samsung Display Co., Ltd., Gyeonggi-do 17113 (KR)
(72) Inventor: CHOI, Minhee, 17113 Yongin-si, Gyeonggi-do (KR); PARK, Minkyung, 17113 Yongin-si, Gyeonggi-do (KR); SUNG, Seungwoo, 17113 Yongin-si, Gyeonggi-do (KR); YOON, Youngsoo, 17113 Yongin-si, Gyeonggi-do (KR); LEE, Bongwon, 17113 Yongin-si, Gyeonggi-do (KR); LEE, Wonse, 17113 Yongin-si, Gyeonggi-do (KR); JANG, Donghyeon, 17113 Yongin-si, Gyeonggi-do (KR); JUNG, Sukyo, 17113 Yongin-si, Gyeonggi-do (KR); JO, Seunghan, 17113 Yongin-si, Gyeonggi-do (KR); HONG, Sunbaek, 17113 Yongin-si, Gyeonggi-do (KR)
(74) Representative: Gulde & Partner

(57) **Abstract**

A display apparatus includes a substrate including a display area and a peripheral area around the display area, a light-emitting element arranged in the display area and a pixel circuit configured to drive the light-emitting element, fan-out wires electrically connected to the pixel circuit and arranged in the peripheral area, a power input wire and a power transfer wire apart from each other in the peripheral area, and a connection member connected to the power input wire through first contact holes and connected to the power transfer wire through second contact holes. The connection member at least partially overlaps the fan-out wires, and a center distance between the first contact holes and a center distance between the second contact holes are not constant.

## Description

### BACKGROUND

### 1. FIELD

One or more embodiments relate to a display apparatus, and more particularly, to a display apparatus in which a high-quality image may be displayed.

### 2. DESCRIPTION OF THE RELATED ART

Generally, a display apparatus includes a light-emitting element and pixel circuits for controlling an electrical signal which is applied to the light-emitting element. The pixel circuits include a thin-film transistor (TFT), a capacitor, and a plurality of wires. The light-emitting element is configured to emit light in response to an electrical signal transmitted from the wires.

For high integration and high reliability of such a display apparatus, active research has been carried out on an arrangement of wiring, etc., not only in a display area but also in a peripheral area around the display area.

### SUMMARY

One or more embodiments include a display apparatus with high reliability in which a high-quality image may be displayed. However, such a technical feature is an example, and one or more embodiments are not limited thereto.

Additional aspects will be set forth in part in the description which follows and, in part, will be apparent from the description, or may be learned by practice of the presented embodiments of the disclosure.

According to one or more embodiments, a display apparatus includes a substrate including a display area and a peripheral area around the display area, a light-emitting element arranged in the display area and a pixel circuit configured to drive the light-emitting element, fan-out wires electrically connected to the pixel circuit and arranged in the peripheral area, a power input wire and a power transfer wire apart from each other in the peripheral area, and a connection member connected to the power input wire through first contact holes and connected to the power transfer wire through second contact holes. The connection member at least partially overlaps the fan-out wires, and a center distance between the first contact holes is not constant. The center distance may refer to a distance between centers of adjacent first contact holes.

A center distance between the second contact holes may not be constant.

The first contact holes may include 1st-1 contact holes above the fan-out wires and 1 st-2 contact holes not above the fan-out wires. A center distance between the 1 st-1 contact holes and the 1 st-2 contact holes adjacent to each other with an edge of the fan-out wires therebetween may be greater than a center distance between the 1st-1 contact holes adjacent to the edge of the fan-out wire.

The number of the first contact holes and the number of the second contact holes may be different from each other.

The first contact holes may include a 1st-1 contact hole above the fan-out wires. The 1st-1 contact hole may be indented at a certain separation distance from edges of the fan-out wires in a plan view.

The separation distance may be at least about 5 µm, preferably 6 µm, more preferably 7 µm.

The pixel circuit may include a first thin-film transistor including a first semiconductor layer and a first gate electrode, and a second thin-film transistor including a second semiconductor layer and a second gate electrode. The first semiconductor layer may be arranged on a layer different from a layer on which the second semiconductor layer is arranged.

At least some of the fan-out wires may be arranged on a same layer on which the first gate electrode is arranged.

The connection member may be arranged on a same layer on which the second gate electrode is arranged.

The display apparatus may further include an organic insulating layer arranged on the power input wire and the power transfer wire. The organic insulating layer may include an opening above at least a portion of the connection member.

The first contact holes may be arranged in two rows in a first direction.

The second contact holes may be arranged in two rows in a first direction.

The power input wire may include a first conductive layer and a second conductive layer stacked on each other.

According to one or more embodiments, a display apparatus includes a substrate including a display area and a peripheral area around the display area, a light-emitting element arranged in the display area and a pixel circuit configured to drive the light-emitting element, a thin-film encapsulation layer covering the light-emitting element and including a first inorganic encapsulation layer, an organic encapsulation layer, and a second inorganic encapsulation layer, fan-out wires electrically connected to the pixel circuit and arranged in the peripheral area, a connection member overlapping the fan-out wires, an interlayer insulating layer covering the connection member and having first contact holes and second contact holes defined therein, and a power input wire and a power transfer wire apart from each other in the peripheral area. The power input wire is connected to the connection member through the first contact holes, the power transfer wire is connected to the connection member through the second contact holes, and the number of the first contact holes is different from the number of the second contact holes.

The first contact holes may include a 1st-1 contact hole above the fan-out wire. The 1st-1 contact hole may be indented at a certain separation distance from edges of the fan-out wires in a plan view.

The first contact holes may include 1st-1 contact holes above the fan-out wire and 1 st-2 contact holes not above the fan-out wire. A center distance between the 1 st-1 contact holes and the 1st-2 contact holes adjacent to each other with an edge of the fan-out wires therebetween may be greater than a center distance between the 1st-1 contact holes adjacent to the edge of the fan-out wire.

The pixel circuit may include a first thin-film transistor including a first semiconductor layer and a first gate electrode, and a second thin-film transistor including a second semiconductor layer and a second gate electrode. The first semiconductor layer may be arranged on a layer different from a layer on which the second semiconductor layer is arranged.

At least some of the fan-out wires may be arranged on a same layer on which the first gate electrode is arranged.

The connection member may be arranged on a same layer on which the second gate electrode is arranged.

The display apparatus may further include an organic insulating layer arranged on the power input wire and the power transfer wire. The organic insulating layer may include an opening above at least a portion of the connection member.

The first inorganic encapsulation layer may be arranged in the opening of the organic insulating layer and may be in direct contact with the interlayer insulating layer.

The first contact holes may be arranged in two rows in a first direction.

The second contact holes may be arranged in two rows in a first direction.

### BRIEF DESCRIPTION OF THE DRAWINGS

The above and other aspects, features, and advantages of certain embodiments of the disclosure will be more apparent from the following description taken in conjunction with the accompanying drawings.
FIG. 1 is a schematic plan view of a portion of a display apparatus according to an embodiment.
FIG. 2 is a schematic side view of the display apparatus of FIG. 1.
FIGS. 3A and 3B are each an equivalent circuit diagram of a sub-pixel included in a display apparatus according to an embodiment.
FIG. 4 is a schematic cross-sectional view of a portion of a display panel according to an embodiment.
FIG. 5 is an enlarged conceptual diagram of a region A of FIG. 1.
FIG. 6 is an enlarged conceptual diagram of a region B of FIG. 5.
FIG. 7 is a schematic cross-sectional view of the region B of FIG. 5, taken along a line II-II' of FIG. 6.
FIG. 8 is a schematic cross-sectional view of the region B of FIG. 5, taken along a line III-III' of FIG. 6.
FIG. 9 is an enlarged plan conceptual diagram of a portion of a display apparatus according to embodiments.
FIG. 10 is an enlarged plan conceptual diagram of a portion of a display apparatus according to embodiments.
FIG. 11 is a schematic cross-sectional view of a portion of a display apparatus according to an embodiment.
FIG. 12 is an enlarged plan conceptual diagram of a portion of a display apparatus according to embodiments.
FIG. 13 is a schematic cross-sectional view of a portion of the display apparatus of FIG. 12, taken along a line IV-IV' of FIG. 12.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof.

As the present description allows for various changes and numerous embodiments, certain embodiments will be illustrated in the drawings and described in the written description. Effects and features of one or more embodiments and methods of accomplishing the same will become apparent from the following detailed description of the one or more embodiments, taken in conjunction with the accompanying drawings. However, the present embodiments may have different forms and should not be construed as being limited to the descriptions set forth herein.

One or more embodiments will be described below in more detail with reference to the accompanying drawings. Those elements that are the same or are in correspondence with each other are rendered the same reference numeral regardless of the figure number, and redundant descriptions thereof are omitted.

It will be understood that, when an element such as a layer, a film, a region, or a plate is referred to as being "on" another element, it may be directly on the other element, or intervening elements may be present therebetween. In addition, sizes of elements in the drawings may be exaggerated or reduced for convenience of explanation. For example, since sizes and thicknesses of elements in the drawings are arbitrarily illustrated for convenience of explanation, the following embodiments are not limited thereto.

The x-axis, the y-axis, and the z-axis are not limited to three axes of the rectangular coordinate system and may be interpreted in a broader sense. For example, the x-axis, the y-axis, and the z-axis may be perpendicular to one another or may represent different directions that are not perpendicular to one another.

While such terms as "first" and "second" may be used to describe various elements, such elements must not be limited to the above terms. The above terms are used only to distinguish one element from another.

It will be further understood that the terms "include," "comprise," and "have" as used herein specify the presence of stated features or elements but do not preclude the addition of one or more other features or elements.

As used herein, the expression "A and/or B" refers to A, B, or A and B. In addition, the expression "at least one of A and B" refers to A, B, or A and B.

It will be further understood that, when layers, regions, or elements are referred to as being connected to each other, they may be directly connected to each other or may be indirectly connected to each other with intervening layers, regions, or elements therebetween. For example, when layers, regions, or elements are referred to as being electrically connected to each other, they may be directly electrically connected to each other or may be indirectly electrically connected to each other with intervening layers, regions, or elements therebetween.

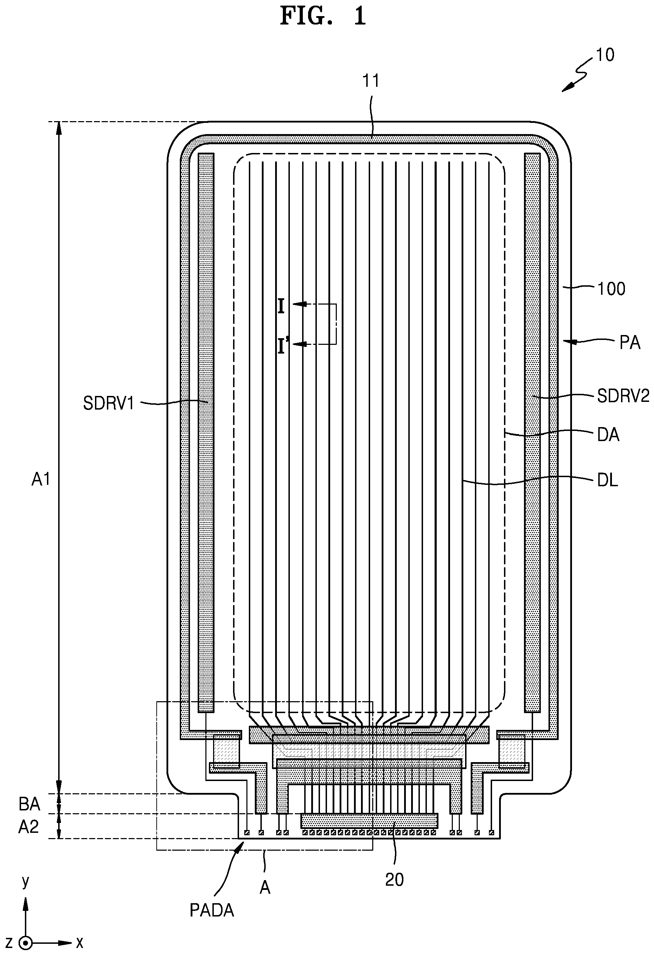

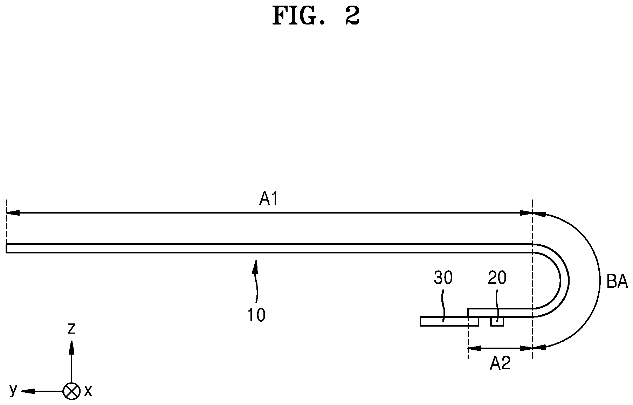

FIG. 1 is a schematic plan view of a portion of a display apparatus according to an embodiment. FIG. 2 is a schematic side view of the display apparatus of FIG. 1. The display apparatus according to the present embodiment may have a portion bent as shown in FIG. 2. However, in FIG. 1, it is shown as not bent for convenience.

The display apparatus according to the present embodiment may include a display panel 10 as shown in FIGS. 1 and 2. The display apparatus may be any display apparatus including the display panel 10. For example, the display apparatus may be a variety of products, such as a smartphone, a tablet, a laptop, a television, or a billboard.

The display panel 10 includes a display area DA in which a plurality of pixels are positioned and a peripheral area PA outside the display area DA. It may be understood as meaning that a substrate 100 included in the display apparatus includes the display area DA and the peripheral area PA. The peripheral area PA includes a pad area PADA to which an electronic element such as a driving chip 20 or a printed circuit board 30 (illustrated in FIG. 2) is electrically attached. A first scan driving circuit SDRV1, a second scan driving circuit SDRV2, and a common voltage supply wire 11 may also be arranged in the peripheral area PA.

The driving chip 20 may include an integrated circuit configured to drive the display panel 10. The integrated circuit may be a data driving integrated circuit configured to generate a data signal, but one or more embodiments are not limited thereto. The driving chip 20 may be mounted in the peripheral area PA to be adjacent to the edge of the substrate 100.

FIG. 1 may be understood as a plan view showing a substrate, etc., during a manufacturing process. In an electronic apparatus such as a final display apparatus or a smartphone including a display apparatus, a portion of the substrate, etc., may be bent to reduce the area of the peripheral area PA recognized by a user. For example, the peripheral area PA may include a bending area BA so that the bending area BA may be between the pad area PADA and the display area DA.

In this case, as shown in FIG. 2, the substrate 100 may be bent in the bending area BA, and thus, a first area A1 on one side of the bending area BA and a second area A2 on the other side of the bending area BA may overlap each other. For example, the substrate 100 may be bent in the bending area BA, and thus, at least a portion of the pad area PADA may overlap the display area DA. Although the driving chip 20 described above is mounted on the same surface as a display surface of the display area DA, the driving chip 20 may be placed over a rear surface of the display area DA as the display panel 10 is bent in the bending area BA.

The display panel 10 may be bent in the bending area BA, and thus, when the display apparatus is viewed from the front (in a direction -z), a peripheral area may not be visible, or even when a peripheral area is visible, a visible area thereof may be reduced. One or more embodiments are not limited to a bent display apparatus and may also be applied to a display apparatus that is not bent.

The substrate 100 may include various materials having flexible or bendable characteristics, and for example, may include polymer resin such as polyethersulfone, polyacrylate, polyetherimide, polyethylene naphthalate, polyethylene terephthalate, polyphenylene sulfide, polyarylate, polyimide, polycarbonate, or cellulose acetate propionate. The substrate 100 may be variously modified, for example, to have a multi-layer structure including two layers including the above polymer resin and a barrier layer between the two layers and including an inorganic material (e.g., silicon oxide, silicon nitride, silicon oxynitride, etc.). Further, when the substrate 100 is not bendable, the substrate 100 may include glass.

The edge of the display area DA may have an overall shape similar to a rectangle or square. Accordingly, the substrate 100 may also have an overall shape similar to a rectangle or square. In an embodiment, the edge of the display area DA may have a shape such as a circle, an oval, or a polygon.

Although an organic light-emitting display apparatus is described below as an example of a display apparatus according to an embodiment, a display apparatus described herein is not limited thereto. In an embodiment, the display apparatus described herein may be a display apparatus such as an inorganic light-emitting display (or inorganic electroluminescent (EL) display) or a quantum dot light-emitting display. For example, an emission layer of a display element included in the display apparatus may include an organic material or an inorganic material. In an embodiment, the display apparatus may include an emission layer, and quantum dots on a path of light emitted from the emission layer.

A plurality of pixels are in the display area DA. Each of the pixels refers to a sub-pixel, and may include a display element such as an organic light-emitting diode (OLED) and a pixel circuit electrically connected to the display element. The pixel may emit, for example, red, green, blue, or white light. The pixel may be electrically connected to outer circuits arranged in the peripheral area PA. The first scan driving circuit SDRV1, the second scan driving circuit SDRV2, and the common voltage supply wire 11 may be arranged in the peripheral area PA.

The first scan driving circuit SDRV1 may extend in a direction y at the edge of the substrate 100. The first scan driving circuit SDRV1 may be configured to provide a scan signal to the pixels through a scan line (not shown) extending into the display area DA in a direction x. The second scan driving circuit SDRV2 may be symmetrical to the first scan driving circuit SDRV1 with the display area DA therebetween. Some of the pixels arranged in the display area DA may be electrically connected to the first scan driving circuit SDRV1, and the others may be electrically connected to the second scan driving circuit SDRV2. In some cases, the second scan driving circuit SDRV2 may be omitted, and all of the pixels arranged in the display area DA may be electrically connected to the first scan driving circuit SDRV1.

In addition, an emission control driving circuit (not shown) may be arranged at a side to the first scan driving circuit SDRV1 or the second scan driving circuit SDRV2, and an emission control signal may be provided to the pixel through an emission control line (not shown) substantially parallel to the scan line.

A plurality of pads may be in the pad area PADA of the display panel 10. The plurality of pads may not be covered by an insulating layer but may be exposed and electrically connected to the printed circuit board 30. That is, pads of the printed circuit board 30 may be electrically connected to the plurality of pads of the display panel 10.

The printed circuit board 30 is configured to transfer a signal or power of a controller to the display panel 10. A control signal generated by the controller may be transmitted to the driving chip 20, the first scan driving circuit SDRV1, and the second scan driving circuit SDRV2 through the printed circuit board 30. In addition, the controller may provide a common voltage VSS to the common voltage supply wire 11 and may provide a driving voltage VDD to driving power wires (not shown) extending in the direction y and extending into the display area DA. For reference, the common voltage supply wire 11 may have a partially open loop shape and thus may have a shape partially surrounding the display area DA.

The controller may generate a data signal, and the generated data signal may be transmitted to the pixel through the driving chip 20 and a data line DL. For reference, the term "line" may refer to a "wire." This also applies to the following embodiments and modifications thereof.

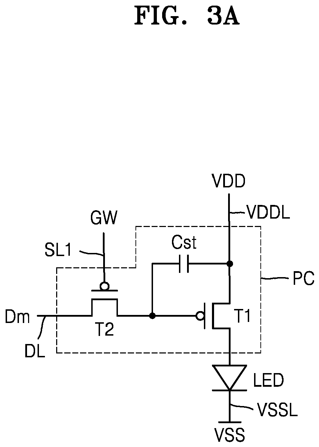

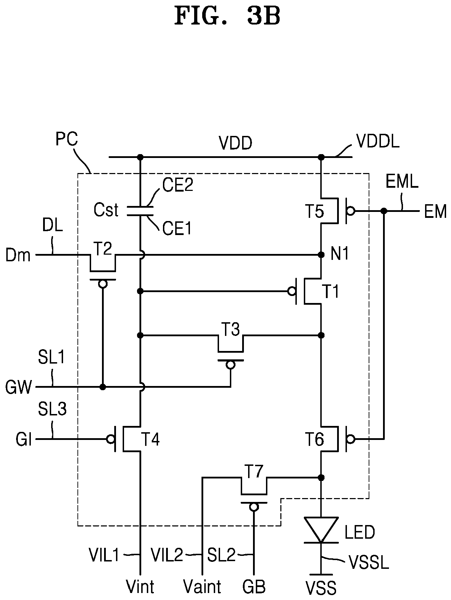

FIGS. 3A and 3B are each an equivalent circuit diagram of a sub-pixel included in a display apparatus according to an embodiment.

Referring to FIG. 3A, a light-emitting element LED corresponding to the sub-pixel may be electrically connected to a pixel circuit PC, and the pixel circuit PC may include a first transistor T1, a second transistor T2, and a storage capacitor Cst. The pixel circuit PC may be electrically connected to a signal line and a voltage line. The signal line may include a gate line such as a first scan line SL1 and the data line DL, and the voltage line may include a first voltage line VDDL.

The second transistor T2 may be electrically connected to the first scan line SL1 and the data line DL. The first scan line SL1 may be configured to provide a first scan signal GW to a gate electrode of the second transistor T2. The second transistor T2 may be configured to transmit a data signal Dm input from the data line DL to the first transistor T1 according to the first scan signal GW input from the first scan line SL1.

The storage capacitor Cst may be electrically connected to the second transistor T2 and the first voltage line VDDL and may store a voltage corresponding to a difference between a voltage received from the second transistor T2 and a first power voltage VDD supplied by the first voltage line VDDL.

The first transistor T1 is a driving transistor and may be configured to control a driving current flowing through the light-emitting element LED. The first transistor T1 may be connected to the first voltage line VDDL and the storage capacitor Cst. The first transistor T1 may be configured to control a driving current flowing from the first voltage line VDDL to the light-emitting element LED, in response to a voltage value stored in the storage capacitor Cst. The light-emitting element LED may emit light having certain brightness according to the driving current. A first electrode of the light-emitting element LED may be electrically connected to the first transistor T1, and a second electrode of the light-emitting element LED may be electrically connected to a second voltage line VSSL configured to supply a second power voltage VSS.

FIG. 3A shows the pixel circuit PC including two transistors T1, T2 and one storage capacitor Cst. However, in an embodiment, the pixel circuit PC may include three or more transistors.

Referring to FIG. 3B, the pixel circuit PC may include the first transistor T1, the second transistor T2, a third transistor T3, a fourth transistor T4, a fifth transistor T5, a sixth transistor T6, a seventh transistor T7, and the storage capacitor Cst.

The pixel circuit PC is electrically connected to signal lines and voltage lines. The signal lines may include gate lines such as the first scan line SL1, a second scan line SL2, a third scan line SL3, and an emission control line EML, and the data line DL. The voltage lines may include first and second initialization voltage lines VIL1 and VIL2 and the first voltage line VDDL.

The first voltage line VDDL may be configured to transfer the first power voltage VDD to the first transistor T1. The first initialization voltage line VIL1 may be configured to transfer a first initialization voltage Vint for initializing the first transistor T1 to the pixel circuit PC. The second initialization voltage line VIL2 may be configured to transfer a second initialization voltage Vaint for initializing the first electrode of the light-emitting element LED to the pixel circuit PC.

The first transistor T1 may be electrically connected to the first voltage line VDDL via the fifth transistor T5 and may be electrically connected to the light-emitting element LED via the sixth transistor T6. The first transistor T1 serves as a driving transistor and is configured to receive the data signal Dm according to a switching operation of the second transistor T2 and supply a driving current to the light-emitting element LED.

The second transistor T2 is a data writing transistor and is electrically connected to the first scan line SL1 and the data line DL. The second transistor T2 is electrically connected to the first voltage line VDDL via the fifth transistor T5. The second transistor T2 is turned on according to the first scan signal GW received through the first scan line SL1 to perform a switching operation for transmitting the data signal Dm transmitted through the data line DL to a first node N1.

The third transistor T3 is electrically connected to the first scan line SL1 and is electrically connected to the light-emitting element LED via the sixth transistor T6. The third transistor T3 may be turned on according to the first scan signal GW received through the first scan line SL1 to diode-connect the first transistor T1.

The fourth transistor T4 is a first initialization transistor and is electrically connected to the third scan line SL3 and the first initialization voltage line VIL1. The fourth transistor T4 is turned on according to a third scan signal GI received through the third scan line SL3 to transfer the first initialization voltage Vint from the first initialization voltage line VIL1 to a gate electrode of the first transistor T1 and initialize a voltage of the gate electrode of the first transistor T1. The third scan signal GI may correspond to a first scan signal of another pixel circuit arranged in a previous row of the corresponding pixel circuit PC.

The fifth transistor T5 may be an operation control transistor, and the sixth transistor T6 may be an emission control transistor. The fifth transistor T5 and the sixth transistor T6 are electrically connected to the emission control line EML, and are simultaneously turned on according to an emission control signal EM received through the emission control line EML to form a current path that allows a driving current to flow in a direction from the first voltage line VDDL to the light-emitting element LED.

The seventh transistor T7 is a second initialization transistor and may be electrically connected to the second scan line SL2, the second initialization voltage line VIL2, and the sixth transistor T6. The seventh transistor T7 may be turned on according to a second scan signal GB received through the second scan line SL2 and may be configured to transfer the second initialization voltage Vaint from the second initialization voltage line VIL2 to the first electrode of the light-emitting element LED and initialize the first electrode of the light-emitting element LED.

The storage capacitor Cst includes a first electrode CE1 and a second electrode CE2. The first electrode CE1 is electrically connected to the gate electrode of the first transistor T1, and the second electrode CE2 is electrically connected to the first voltage line VDDL. The storage capacitor Cst may maintain a voltage applied to the gate electrode of the first transistor T1 by storing and maintaining a voltage corresponding to a voltage difference between two ends of the first voltage line VDDL and the gate electrode of the first transistor T1.

In FIG. 3B, the plurality of transistors T1 to T7 are all shown as P type, but one or more embodiments are not limited thereto. Various modifications may be made, for example, at least one of the plurality of transistors T1 to T7 may be n type.

In an embodiment, at least one of the plurality of transistors T1 to T7 may include a semiconductor layer including oxide, and the others may include a semiconductor layer including silicon. For example, the third transistor T3 and the fourth transistor T4 may include an oxide semiconductor layer, and the other transistors may include a silicon semiconductor layer. However, one or more embodiments are not limited thereto. All of the plurality of transistors T1 to T7 may include a silicon semiconductor layer.

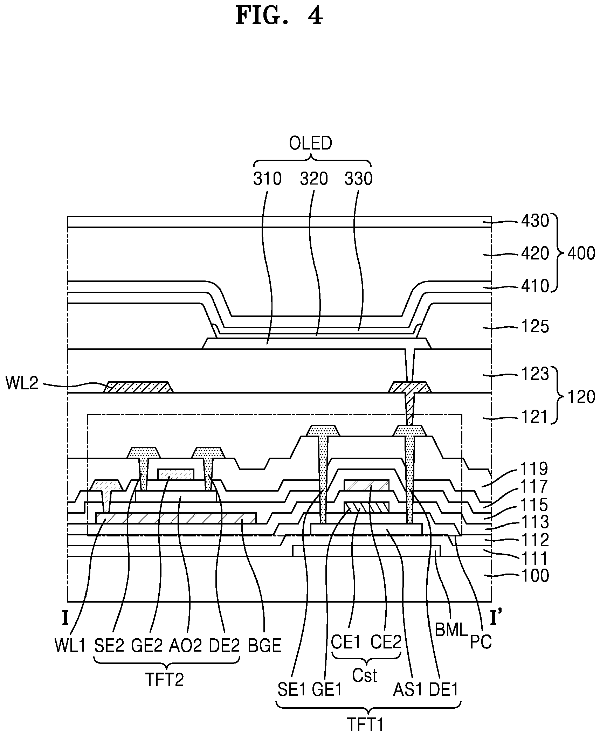

FIG. 4 is a schematic cross-sectional view of a portion of the display panel 10 according to an embodiment and is a schematic cross-sectional view thereof corresponding to a line I-I' of FIG. 1.

Referring to FIG. 4, the pixel circuit PC may be disposed over the substrate 100 of the display panel 10, and an organic light-emitting diode OLED may be arranged as a light-emitting element connected to the pixel circuit PC. In addition, a bottom conductive layer BML may be further disposed between the substrate 100 and the pixel circuit PC.

The pixel circuit PC according to the present embodiment may include a first thin-film transistor TFT1 including a silicon semiconductor and a second thin-film transistor TFT2 including an oxide semiconductor. The pixel circuit PC may further include the storage capacitor Cst.

The first thin-film transistor TFT1 includes a first semiconductor layer AS1 including a silicon semiconductor and a first gate electrode GE1 insulated from the first semiconductor layer AS1. The first thin-film transistor TFT1 may include a first source electrode SE1 and/or a first drain electrode DE1 connected to the first semiconductor layer AS1. The first thin-film transistor TFT1 may serve as a driving thin-film transistor.

The second thin-film transistor TFT2 includes a second semiconductor layer AO2 including an oxide semiconductor and a second gate electrode GE2 insulated from the second semiconductor layer AO2. The second thin-film transistor TFT2 may include a second source electrode SE2 and/or a second drain electrode DE2 connected to the second semiconductor layer AO2. The second thin-film transistor TFT2 may serve as a switching thin-film transistor. In an embodiment, the second thin-film transistor TFT2 may be any thin-film transistor other than a driving thin-film transistor.

According to an embodiment, the first semiconductor layer AS1 of the first thin-film transistor TFT1 serving as a driving thin-film transistor may include polycrystalline silicon with excellent reliability, and the second semiconductor layer AO2 of the second thin-film transistor TFT2 corresponding to a switching thin-film transistor may include an oxide semiconductor with low leakage current.

More specifically, a driving thin-film transistor which directly affects the brightness of a display element may include a semiconductor layer formed of polycrystalline silicon with high reliability, thereby implementing a high-resolution display apparatus.

A thin-film transistor including an oxide semiconductor has high carrier mobility and low leakage current, and thus, a voltage drop is not significant even when a driving time is long. It means that a thin-film transistor including an oxide semiconductor does not have a significant color change in an image due to a voltage drop even during low-frequency driving, which makes low-frequency driving possible. Accordingly, when a driving circuit includes a thin-film transistor including a semiconductor layer formed of an oxide semiconductor, power consumption may be reduced compared to a case where all thin-film transistors included in a driving circuit include a semiconductor layer formed of polycrystalline silicon.

In the present embodiments, at least one of the other thin-film transistors excluding the driving thin-film transistor may include an active layer formed of an oxide semiconductor, thereby reducing power consumption of a display apparatus.

In addition, the bottom conductive layer BML overlapping the first thin-film transistor TFT1 is disposed under the first thin-film transistor TFT1 according to the present embodiment. Constant voltage may be applied to the bottom conductive layer BML. Because the bottom conductive layer BML is disposed under the first thin-film transistor TFT1, the first thin-film transistor TFT1 may be less affected by surrounding interference signals to have improved reliability.

In the present embodiment, it is assumed that an organic light-emitting diode is employed as a light-emitting element. However, in an embodiment, an inorganic light-emitting element or a quantum dot light-emitting element may be employed as a light-emitting element.

Hereinafter, a structure in which configurations included in the display panel 10 are stacked on each other will be described.

The substrate 100 may include an insulating material, such as glass, quartz, or polymer resin. The substrate 100 may be a rigid substrate, or a flexible substrate which is bendable, foldable, or rollable. The substrate 100 may have a single-layer or multi-layer structure including the above material. In the case of a multi-layer structure, the substrate 100 may further include an inorganic layer. In some embodiments, the substrate 100 may have a structure of an organic material/an inorganic material/an organic material.

A buffer layer 111 may be positioned on the substrate 100 to decrease or prevent penetration of foreign substances, moisture, or external air from below the substrate 100 and may provide a flat surface on the substrate 100. The buffer layer 111 may include an inorganic material, such as oxide or nitride, an organic material, or an organic-inorganic compound, and may have a single-layer or multi-layer structure including an inorganic material and an organic material. In some embodiments, the buffer layer 111 may include silicon oxide (SiO₂) or silicon nitride (SiNx).

The bottom conductive layer BML may be disposed between the substrate 100 and the buffer layer 111. The bottom conductive layer BML may include a conductive material. In some embodiments, the bottom conductive layer BML may include a transparent conductive material. For example, the bottom conductive layer BML may include conductive oxide, such as indium tin oxide (ITO), indium zinc oxide (IZO), zinc oxide (ZnO), indium oxide (In₂O₃), indium gallium oxide (IGO), or aluminum zinc oxide (AZO). The bottom conductive layer BML may overlap the first thin-film transistor TFT1, and a constant voltage may be applied to the bottom conductive layer BML. A barrier layer (not shown) that prevents penetration of external air may be further between the substrate 100 and the bottom conductive layer BML. The barrier layer may include an inorganic material, such as oxide or nitride, an organic material, or an organic-inorganic compound, and may have a single-layer or multi-layer structure including an inorganic material and an organic material.

The first semiconductor layer AS1 including a silicon semiconductor may be disposed on the buffer layer 111, and the first semiconductor layer AS1 may include polysilicon or amorphous silicon. The first semiconductor layer AS1 may include a channel region, and source and drain regions doped with impurities.

A first gate insulating layer 112 may cover the first semiconductor layer AS1. The first gate insulating layer 112 may include an inorganic insulating material such as silicon oxide (SiO₂), silicon nitride (SiNₓ), silicon oxynitride (SiOₓN_{y}), aluminum oxide (Al₂O₃), titanium oxide (TiO₂), etc. The first gate insulating layer 112 may have a single-layer or multi-layer structure including the above-described inorganic insulating material.

The first gate electrode GE1 is disposed on the first gate insulating layer 112 to overlap the first semiconductor layer AS1. The first gate electrode GE1 may include molybdenum (Mo), aluminum (Al), copper (Cu), titanium (Ti), etc., and may include a single layer or a plurality of layers. As an example, the first gate electrode GE1 may include a single Mo layer.

A second gate insulating layer 113 may cover the first gate electrode GE1. The second gate insulating layer 113 may include an inorganic insulating material such as silicon oxide (SiO₂), silicon nitride (SiNₓ), silicon oxynitride (SiOₓN_{y}), aluminum oxide (Al₂O₃), titanium oxide (TiO₂), etc. The second gate insulating layer 113 may have a single-layer or multi-layer structure including the above-described inorganic insulating material.

The storage capacitor Cst may overlap the first gate electrode GE1. The storage capacitor Cst includes the first electrode CE1 and the second electrode CE2. The second gate insulating layer 113 may be disposed between the first electrode CE1 and the second electrode CE2. In this regard, the first gate electrode GE1 may serve not only as a gate electrode of the first thin-film transistor TFT1 but also as the first electrode CE1 of the storage capacitor Cst. That is, the first gate electrode GE1 and the first electrode CE1 may be integrally formed as a single body. The second electrode CE2 is disposed on the second gate insulating layer 113 to at least partially overlap the first electrode CE1.

A first wire WL1 and a bottom gate electrode BGE may be disposed on the second gate insulating layer 113. The first wire WL1 may be configured to transmit a signal which is transmitted to the first thin-film transistor TFT1 or the second thin-film transistor TFT2. The bottom gate electrode BGE may overlap the second semiconductor layer AO2 of the second thin-film transistor TFT2 and apply a gate signal to the second thin-film transistor TFT2. In this case, the second thin-film transistor TFT2 may have a double gate electrode structure in which gate electrodes are disposed over and under the second semiconductor layer AO2.

The bottom gate electrode BGE may be provided as part of the first wire WL1. In this case, the first wire WL1 may be configured to transmit a gate signal to the second thin-film transistor TFT2.

The second gate insulating layer 113 may include an inorganic material including oxide or nitride. For example, the second gate insulating layer 113 may include silicon oxide (SiO₂), silicon nitride (SiNₓ), silicon oxynitride (SiON), aluminum oxide (Al₂O₃), titanium oxide (TiO₂), etc.

A first interlayer insulating layer 115 may cover the second electrode CE2, the first wire WL1, and the bottom gate electrode BGE. The first interlayer insulating layer 115 may include silicon oxide (SiO₂), silicon nitride (SiNₓ), silicon oxynitride (SiOₓN_{y}), aluminum oxide (Al₂O₃), titanium oxide (TiO₂), etc. The first interlayer insulating layer 115 may have a single-layer or multi-layer structure including the above-described inorganic insulating material.

The second semiconductor layer AO2 including an oxide semiconductor may be disposed on the first interlayer insulating layer 115. The second semiconductor layer AO2 may include a channel region, and source and drain regions arranged on both sides of the channel region. The second semiconductor layer AO2 may include oxide of at least one material selected from the group including indium (In), gallium (Ga), tin (Sn), zirconium (Zr), hafnium (Hf), titanium (Ti), and zinc (Zn). In some embodiments, the second semiconductor layer AO2 may be an IGZO (In-Ga-Zn-O) semiconductor containing metals, such as indium (In) and gallium (Ga), in ZnO.

The source and drain regions of the second semiconductor layer AO2 may be formed by a conductivizing process, e.g., by adjusting carrier concentration of the oxide semiconductor. For example, the source and drain regions of the second semiconductor layer AO2 may be formed by increasing carrier concentration of the oxide semiconductor using a plasma treatment with, e.g., hydrogen(H)-based gases, fluorine(F)-based gases, or combinations thereof.

The second gate electrode GE2 may be disposed over the second semiconductor layer AO2, and a second interlayer insulating layer 117 may be disposed between the second semiconductor layer AO2 and the second gate electrode GE2. The second gate electrode GE2 overlaps the second semiconductor layer AO2 and is insulated from the second semiconductor layer AO2 by the second interlayer insulating layer 117.

The second interlayer insulating layer 117 may include silicon oxide (SiO₂), silicon nitride (SiNₓ), silicon oxynitride (SiOₓN_{y}), aluminum oxide (Al₂O₃), titanium oxide (TiO₂), tantalum oxide (Ta₂O₅), hafnium oxide (HfO₂), or zinc oxide (ZnO₂). The second interlayer insulating layer 117 may have a single-layer or multi-layer structure including the above-described inorganic insulating material.

A third interlayer insulating layer 119 may be disposed on the second gate electrode GE2, and the first source electrode SE1 and/or the first drain electrode DE1 connected to the first semiconductor layer AS1 and the second source electrode SE2 and/or the second drain electrode DE2 connected to the second semiconductor layer AO2 may be disposed on the third interlayer insulating layer 119. In addition, a data line for transmitting a data signal and a driving voltage line for transferring a driving voltage may be disposed on the third interlayer insulating layer 119. The first source electrode SE1, the first drain electrode DE1, the second source electrode SE2, or the second drain electrode DE2 may be connected to the data line or the driving voltage line directly or through another thin-film transistor.

The third interlayer insulating layer 119 may include silicon oxide (SiO₂), silicon nitride (SiNₓ), silicon oxynitride (SiOₓN_{y}), aluminum oxide (Al₂O₃), titanium oxide (TiO₂), tantalum oxide (Ta₂O₅), hafnium oxide (HfO₂), or zinc oxide (ZnO₂). The third interlayer insulating layer 119 may have a single-layer or multi-layer structure including the above-described inorganic insulating material.

The first source electrode SE1 and/or the first drain electrode DE1 and the second source electrode SE2 and/or the second drain electrode DE2 may include a highly conductive material such as metal, conductive oxide, etc. For example, the first source electrode SE1 and/or the first drain electrode DE1 and the second source electrode SE2 and/or the second drain electrode DE2 may have a single-layer or multi-layer structure including aluminum (Al), copper (Cu), titanium (Ti), etc. In some embodiments, the first source electrode SE1 and/or the first drain electrode DE1 and the second source electrode SE2 and/or the second drain electrode DE2 may have a triple-layer structure of titanium, aluminum, and titanium (Ti/AI/Ti) sequentially disposed on one another.

An organic insulating layer 120 is disposed on the first source electrode SE1 and/or the first drain electrode DE1 and the second source electrode SE2 and/or the second drain electrode DE2. The organic insulating layer 120 may include a single layer or a plurality of layers. For example, the organic insulating layer 120 may have a first organic insulating layer 121 and a second organic insulating layer 123 stacked on each other. In this case, a second wire WL2 may be disposed between the first organic insulating layer 121 and the second organic insulating layer 123, and thus, integration density may be improved.

The organic insulating layer 120 may include a general commercial polymer, such as photosensitive polyimide, polyimide, polycarbonate (PC), benzocyclobutene (BCB), hexamethyldisiloxane (HMDSO), poly(methyl methacrylate) (PMMA), or polystyrene (PS), a polymer derivative having a phenol-based group, an acryl-based polymer, an imide-based polymer, an aryl ether-based polymer, an amide-based polymer, a fluorine-based polymer, a p-xylene-based polymer, or a vinyl alcohol-based polymer.

In an embodiment, the organic insulating layer 120 may include a siloxane-based organic material. The siloxane-based organic material may include hexamethyldisiloxane, octamethyltrisiloxane, decamethyltetrasiloxane, dodecamethylpentasiloxane, and polydimethylsiloxanes. The organic insulating layer 120 may serve as a protection layer covering thin-film transistors.

The organic light-emitting diode OLED including a pixel electrode 310, an opposite electrode 330, and an intermediate layer 320 disposed therebetween and including an emission layer may be on the organic insulating layer 120.

The pixel electrode 310 may be connected to the first drain electrode DE1 through a contact hole defined in the organic insulating layer 120 and may be connected to a first drain region of the first thin-film transistor TFT1 by the first drain electrode DE1. The pixel electrode 310 may be directly connected to the first thin-film transistor TFT1 or may be indirectly connected to the first thin-film transistor TFT1 via another thin-film transistor (not shown) configured to control light emission.

The pixel electrode 310 may include conductive oxide, such as indium tin oxide (ITO), indium zinc oxide (IZO), zinc oxide (ZnO), indium oxide (In₂O₃), indium gallium oxide (IGO), or aluminum zinc oxide (AZO). The pixel electrode 310 may include a reflection layer including silver (Ag), magnesium (Mg), aluminum (Al), or a compound thereof. For example, the pixel electrode 310 may have a structure including layers formed of ITO, IZO, ZnO, or In₂O₃ on/under the above-described reflection layer. In this case, the pixel electrode 310 may have a stack structure of ITO/Ag/ITO.

A pixel-defining layer 125 may be disposed on the organic insulating layer 120. The pixel-defining layer 125 covers the edge of the pixel electrode 310, and has an opening exposing a central portion of the pixel electrode 310 and thus defines a pixel. In addition, the pixel-defining layer 125 may prevent an arc, etc., from occurring at the edge of the pixel electrode 310 by increasing a distance between the edge of the pixel electrode 310 and the opposite electrode 330 above the pixel electrode 310. The pixel-defining layer 125 may include an organic insulating material such as polyimide, polyamide, acrylic resin, BCB, HMDSO, and phenolic resin and may be formed by a method such as spin coating.

The intermediate layer 320 of the organic light-emitting diode OLED may include a low-molecular weight material or a polymer material and may emit red, green, blue, or white light. When the intermediate layer 320 includes a low-molecular material, the intermediate layer 320 may have a structure in which a hole injection layer (HIL), a hole transport layer (HTL), an emission layer (EML), an electron transport layer (ETL), and an electron injection layer (EIL) are stacked in a single or complex structure, and may include various organic materials including copper phthalocyanine (CuPc), N,N'-Di(naphthalene-1-yl)-N,N'-diphenylbenzidine (NPB), and tris-8-hydroxyquinoline aluminum (Alq3). These layers may be formed by vacuum deposition.

When the intermediate layer 320 includes a polymer material, the intermediate layer 320 may have a structure including an HTL and an EML. In this regard, the HTL may include poly(3,4-ethylenedioxythiophene) (PEDOT), and the EML may include a polymer material such as a polyphenylene vinylene (PPV)-based material and a polyfluorene-based material. The intermediate layer 320 may be formed by screen printing, inkjet printing, laser induced thermal imaging (LITI), or the like.

The intermediate layer 320 is not limited thereto and may have any of various other structures. In addition, the intermediate layer 320 may include a single layer over a plurality of pixel electrodes 310 or may include patterned layers respectively corresponding to the plurality of pixel electrodes 310.

The opposite electrode 330 is disposed on the intermediate layer 320. The opposite electrode 330 may include a conductive material having a low work function. For example, the opposite electrode 330 may include a (semi)transparent layer including silver (Ag), magnesium (Mg), aluminum (Al), platinum (Pt), lithium (Li), calcium (Ca), or an alloy thereof. In an embodiment, the opposite electrode 330 may further include a layer, such as ITO, IZO, ZnO, or In₂O₃, on a (semi)transparent layer including the above material. The opposite electrode 330 may be integrally formed as a single body for a plurality of organic light-emitting diodes to correspond to the plurality of pixel electrodes 310.

The organic light-emitting diode OLED may be encapsulated by a thin-film encapsulation layer 400. The thin-film encapsulation layer 400 may prevent external moisture or foreign substances from penetrating into the organic light-emitting diode OLED.

In some embodiments, the thin-film encapsulation layer 400 may include at least one inorganic encapsulation layer and at least one organic encapsulation layer as shown in FIG. 4. In an embodiment, the thin-film encapsulation layer 400 may include first and second inorganic encapsulation layers 410 and 430 and an organic encapsulation layer 420 therebetween.

The first inorganic encapsulation layer 410 and the second inorganic encapsulation layer 430 may include one or more inorganic insulating materials such as silicon oxide (SiO₂), silicon nitride (SiNₓ), silicon oxynitride (SiOₓN_{y}), aluminum oxide (Al₂O₃), titanium oxide (TiO₂), tantalum oxide (Ta₂O₅), hafnium oxide (HfO₂), or zinc oxide (ZnO₂), and may be formed by chemical vapor deposition (CVD). The organic encapsulation layer 420 may include a polymer-based material. Examples of the polymer-based material may include silicone-based resin, acryl-based resin, epoxy-based resin, polyimide, and polyethylene.

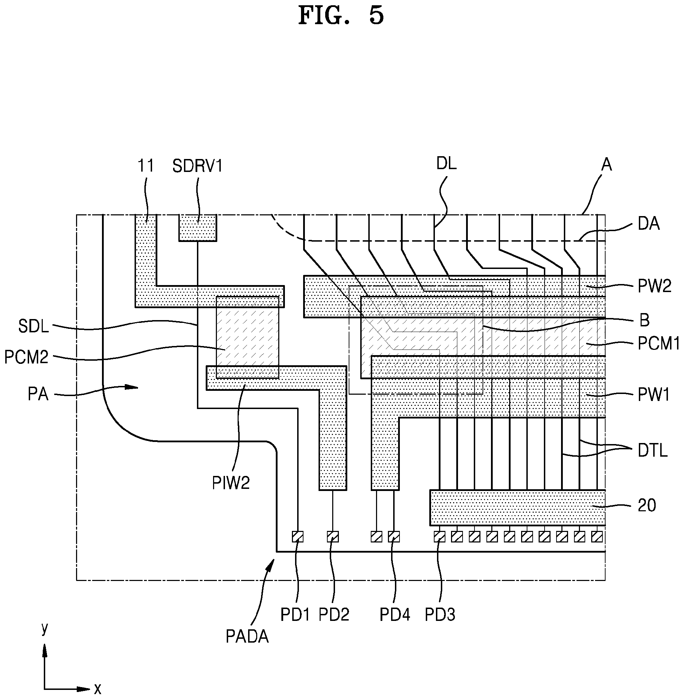

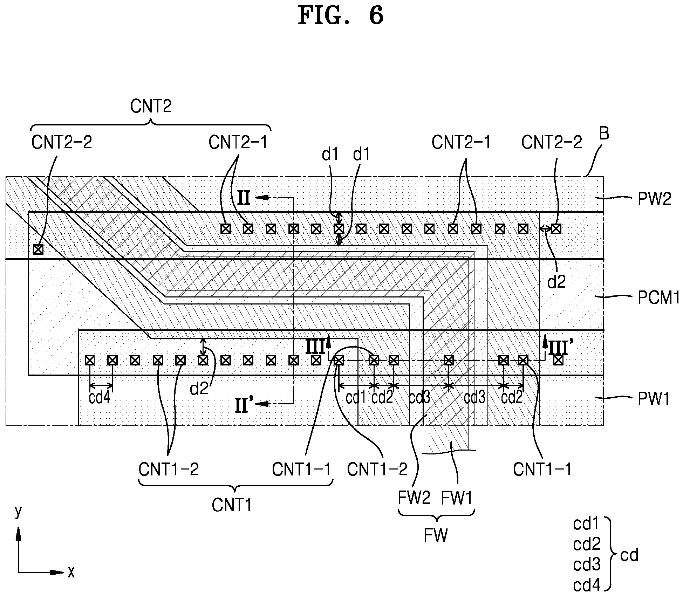

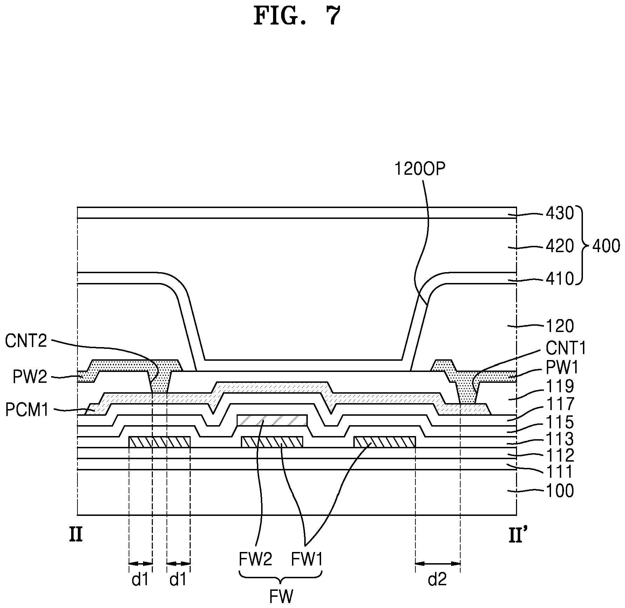

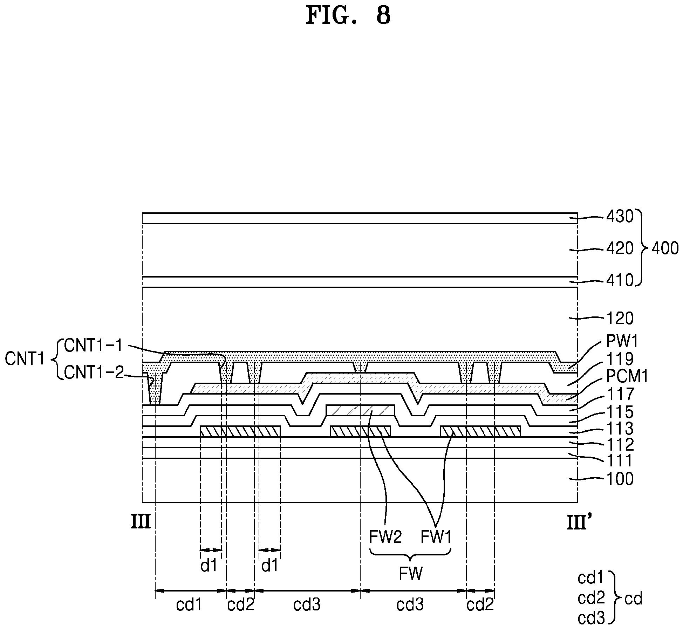

FIG. 5 is an enlarged conceptual diagram of a region A of FIG. 1. FIG. 6 is an enlarged conceptual diagram of a region B of FIG. 5. FIG. 7 is a schematic cross-sectional view of the region B of FIG. 5, taken along a line II-II' of FIG. 6. FIG. 8 is a schematic cross-sectional view of the region B of FIG. 5, taken along a line III-III' of FIG. 6.

Referring to FIG. 5, a first pad PD1, a second pad PD2, a third pad PD3, and a fourth pad PD4 are near a lower edge of the substrate 100.

A scan driving circuit line SDL may be positioned in the peripheral area PA to be adjacent to a left edge of the substrate 100 and may be electrically connected to the first scan driving circuit SDRV1 and the first pad PD1. Accordingly, a control signal input from a printed circuit board, e.g., the printed circuit board 30 of FIG. 2, through the first pad PD1 may be transmitted to the first scan driving circuit SDRV1 through the scan driving circuit line SDL.

The second pad PD2 may be connected to a common power input wire PIW2. The common power input wire PIW2 may include a first portion extending substantially in the direction x and a second portion protruding from the first portion and extending in a direction -y. The second portion of the common power input wire PIW2 may be electrically connected to the second pad PD2.

The common voltage supply wire 11 may include a first portion extending in the direction x to be substantially parallel to the first portion of the common power input wire PIW2. A common power connection member PCM2 may electrically connect the common voltage supply wire 11 and the common power input wire PIW2 to each other. The common power connection member PCM2 may overlap the first portion of the common voltage supply wire 11 and the first portion of the common power input wire PIW2 and may be connected thereto through contact holes, respectively.

A data signal of a controller input from the printed circuit board through the third pad PD3 may be transmitted to data lines DL in the display area DA through the driving chip 20 and data transfer lines DTL and be finally transmitted to pixels. To this end, the data transfer lines DTL may be in the peripheral area PA. In addition, each of the data transfer lines DTL may extend in the direction y. The data transfer line DTL may be a fan-out wire FW.

A driving power input wire PW1 positioned in the peripheral area PA to be adjacent to the lower edge of the substrate 100 may include a first portion extending substantially in the direction x and a second portion protruding from the first portion and extending in the direction y. The second portion of the driving power input wire PW1 may be electrically connected to the fourth pad PD4.

A plurality of driving voltage lines (not shown) extending in the direction y and extending into the display area DA may be electrically connected to a driving power transfer wire PW2 extending in the direction x to be substantially parallel to the first portion of the driving power input wire PW1. The plurality of driving voltage lines may be substantially parallel to a plurality of data lines DL in the display area DA.

The driving power input wire PW1 and the driving power transfer wire PW2 may be referred to as a power input wire and a power transfer wire, respectively. The driving power input wire PW1 and the driving power transfer wire PW2 may be arranged in the peripheral area PA to correspond to one side of the display area DA.

A driving power connection member PCM1 is a connection member connecting the driving power input wire PW1 and the driving power transfer wire PW2 to each other and may electrically connect the driving power input wire PW1 and the driving power transfer wire PW2 to each other. The driving power connection member PCM1 may be referred to as a connection member.

Referring to FIGS. 6 and 7, one end of the driving power connection member PCM1 in the direction -y may overlap the driving power input wire PW1 from below the driving power input wire PW1 and may be connected to the driving power input wire PW1 through first contact holes CNT1 defined in the third interlayer insulating layer 119 thereon.

One end of the driving power connection member PCM1 in a direction +y may overlap the driving power transfer wire PW2 from below the driving power transfer wire PW2 and may be connected to the driving power transfer wire PW2 through second contact holes CNT2 defined in the third interlayer insulating layer 119 thereon.

The driving power connection member PCM1 may include the same material as that of the second gate electrode GE2, and may be disposed on the second interlayer insulating layer 117, which is a layer on which the second gate electrode GE2 is disposed. The driving power input wire PW1 and the driving power transfer wire PW2 may include the same material as that of the first source electrode SE1, the first drain electrode DE1, the second source electrode SE2, and the second drain electrode DE2, and may be disposed on the third interlayer insulating layer 119.

The driving power connection member PCM1 may overlap a plurality of fan-out wires FW disposed below the driving power connection member PCM1. The fan-out wires FW may include first fan-out wires FW1 and second fan-out wires FW2. The first fan-out wires FW1 are wires disposed on the first gate insulating layer 112 in the peripheral area PA and may be configured to transfer an electrical signal or constant voltage to the display area DA. The first fan-out wires FW1 may include the same material as that of the first gate electrode GE1. The second fan-out wires FW2 are wires disposed on the second gate insulating layer 113 in the peripheral area PA and may be configured to transfer an electrical signal or constant voltage to the display area DA. The second fan-out wires FW2 may include the same material as that of the second electrode CE2 of the storage capacitor Cst. Some of the fan-out wires FW may be the data transfer lines DTL (refer to FIG. 5). Some of the fan-out wires FW may be initialization voltage lines configured to transfer initialization voltage to a pixel circuit.

A second fan-out wire FW2 may overlap a first fan-out wire FW1. However, one or more embodiments are not limited thereto. Various modifications may be made, for example, the first fan-out wire FW1 and the second fan-out wire FW2 may alternate with each other.

Because the fan-out wires FW described above are disposed below the driving power connection member PCM1, a step difference which occurs at the edge of the fan-out wires FW is reflected in the driving power connection member PCM1 and insulating layers thereunder according to positions of the fan-out wires FW, and thus, a step structure may also be formed in the driving power connection member PCM1 and the insulating layers thereunder.

When the first contact holes CNT1 or the second contact holes CNT2 are formed in such a curved region, a defect such as cracks may occur in the first contact holes CNT1 or the second contact holes CNT2 due to the step structure.

According to one or more embodiments, positions of the first contact holes CNT1 and the second contact holes CNT2 may be selected by taking into account positions of the fan-out wires FW disposed below the driving power connection member PCM1. For example, lower edges of the first contact holes CNT1 and the second contact holes CNT2 may be apart from an edge of the fan-out wire FW by certain distances d1 and d2 or greater in a plan view. The certain distances d1 and d2 may be about 5 µm. When the distances d1 and d2 are less than 5 µm, the curved region of the insulating layers resulting from ends of the fan-out wires FW may overlap contact holes, thereby causing a defect in the contact holes.

The first contact holes CNT1 and the second contact holes CNT2 may be arranged inside or outside the fan-out wire FW in a plan view not to overlap the edge of the fan-out wire FW.

The first contact holes CNT1 may include 1st-1 contact holes CNT1-1 overlapping, e.g., above, the fan-out wire FW and 1st-2 contact holes CNT1-2 not overlapping, e.g., not above, the fan-out wire FW. In the same way, the second contact holes CNT2 may include 2nd-1 contact holes CNT2-1 overlapping, e.g., above, the fan-out wire FW and 2nd-2 contact holes CNT2-2 not overlapping, e.g., not above, the fan-out wire FW.

The 1st-1 contact holes CNT1-1 and the 2nd-1 contact holes CNT2-1 may overlap the fan-out wire FW and may be apart from the edge of the fan-out wire FW by the certain first distance d1.

The 1st-2 contact holes CNT1-2 and the 2nd-2 contact holes CNT2-2 may not overlap the fan-out wire FW and may be apart from the edge of the fan-out wire FW by the certain second distance d2.

The first contact holes CNT1 and the second contact holes CNT2 may be arranged in the direction x according to such an arrangement, but a center distance cd between adjacent first contact holes CNT1 and a center distance cd between adjacent second contact holes CNT2 may not be constant.

For example, a first center distance cd1, which is a center distance between a 1st-1 contact hole CNT1-1 and a 1st-2 contact hole CNT1-2 adjacent to each other with the edge of the fan-out wires FW therebetween from among the first contact holes CNT1, may be greater than a second center distance cd2, which is a center distance between two 1st-1 contact holes CNT1-1 overlapping the fan-out wire FW and adjacent to each other.

In addition, a third center distance cd3, which is a center distance between a 1st-1 contact hole CNT1-1 overlapping the first fan-out wire FW1 and a 1st-1 contact hole CNT1-1 overlapping the second fan-out wire FW2 adjacent to the first fan-out wire FW1, may be greater than the first center distance cd1.

A fourth center distance cd4, which is a center distance between two 1st-2 contact holes CNT1-2 not overlapping the fan-out wire FW and adjacent to each other, may be less than the first center distance cd1. In some embodiments, the fourth center distance cd4 may be the same as the second center distance cd2.

Because the fan-out wires FW overlapping the driving power connection member PCM1 include a portion extending in the direction y, a portion extending in the direction x, and a portion extending at a certain angle to the direction x, the first contact holes CNT1 and the second contact holes CNT2 may not have a one-to-one correspondence. For example, the number of first contact holes CNT1 and the number of second contact holes CNT2 may not be the same and may be different from each other.

As shown in FIG. 7, in a display panel according to the present embodiment, the organic insulating layer 120 including an organic material may have an opening 120OP in the peripheral area PA, and thus, the third interlayer insulating layer 119, which is an inorganic material layer thereunder, may be exposed. The opening 120OP in the organic insulating layer 120 may extend in the direction x. The opening 120OP may at least partially overlap the driving power connection member PCM1.

The first inorganic encapsulation layer 410 of the thin-film encapsulation layer 400 may be in direct contact with the third interlayer insulating layer 119, which is an inorganic material layer. The first inorganic encapsulation layer 410 of the thin-film encapsulation layer 400 has adhesion to a layer including an inorganic material greater than adhesion to a layer including an organic material. Accordingly, the organic insulating layer 120 including an organic material may have the opening 120OP extending in the direction x so that the first inorganic encapsulation layer 410 of the thin-film encapsulation layer 400 may be in direct contact with the third interlayer insulating layer 119, which is an inorganic material layer, and thus, the thin-film encapsulation layer 400 may firmly adhere to a layer thereunder. In an embodiment, because the driving power connection member PCM1 and the common power connection member PCM2 may be stated to be an inorganic material layer including metal, the first inorganic encapsulation layer 410 of the thin-film encapsulation layer 400 may be brought into direct contact with the inorganic material layer including metal.

In an embodiment, because the driving power input wire PW1 and the driving power transfer wire PW2 may also be stated to be an inorganic material layer including metal, it may be considered that the driving power input wire PW1 and the driving power transfer wire PW2 are connected to each other through the driving power connection member PCM1 and the first inorganic encapsulation layer 410 of the thin-film encapsulation layer 400 is brought into contact with the driving power connection member PCM1 through the driving power input wire PW1 and the driving power transfer wire PW2. However, when the driving power input wire PW1 and the driving power transfer wire PW2 have a three-layer structure of Ti/AI/Ti, an etch rate for Al is higher than an etch rate for Ti during a manufacturing process, and accordingly, a tip in which the uppermost Ti layer protrudes beyond the Al layer may be formed. In addition, such a tip may separate from the driving power input wire PW1 and the driving power transfer wire PW2 during the manufacturing process and come into contact with another conductive layer, thereby causing a defect in a display apparatus.

In a display apparatus according to the present embodiment, during a manufacturing process, the driving power input wire PW1 and the driving power transfer wire PW2 are covered by the organic insulating layer 120 immediately after being formed. In addition, the driving power input wire PW1 and the driving power transfer wire PW2 are electrically connected to each other by the driving power connection member PCM1 thereunder. Accordingly, a defect may be effectively prevented from occurring during the manufacturing process, and further, the first inorganic encapsulation layer 410 may be brought into contact with the driving power connection member PCM1, which is an inorganic material layer, at the outside of the display area DA or brought into direct contact with the third interlayer insulating layer 119, which is an inorganic insulating layer covering the same, and thus, an excellent encapsulation effect may be obtained.

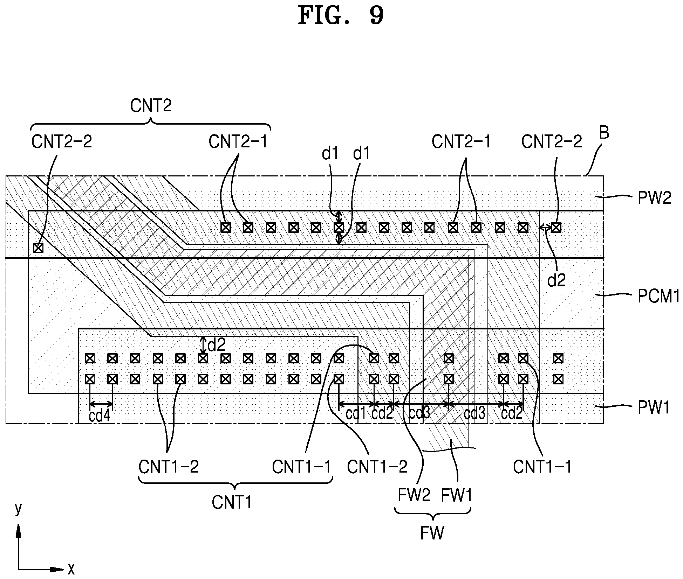

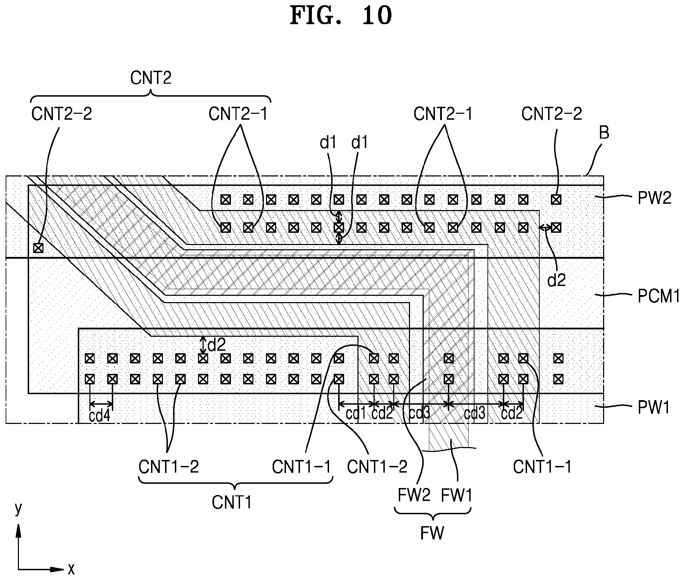

FIGS. 9 and 10 are enlarged plan conceptual diagrams of a portion of a display apparatus according to embodiments. More specifically, FIGS. 9 and 10 show part of a peripheral area of a display panel. In FIGS. 9 and 10, elements that are the same as those in FIG. 6 are designated by the same reference numerals.

Referring to FIGS. 9 and 10, the fan-out wires FW, the driving power input wire PW1, the driving power transfer wire PW2, and the driving power connection member PCM1 may be arranged in the peripheral area of the display panel.

The fan-out wires FW are wires configured to transfer an electrical signal, constant voltage, etc., to a display area, and may extend substantially in the direction y but may include a curved portion. The fan-out wires FW may include a portion extending in the direction y, a portion extending in the direction x, and a portion extending between the direction x and the direction y.

The driving power input wire PW1 may extend in the direction x and may be connected to the driving power connection member PCM1 through a plurality of first contact holes CNT1. The driving power input wire PW1 may overlap the fan-out wires FW. The driving power transfer wire PW2 may extend in the direction x and may be connected to the driving power connection member PCM1 through a plurality of second contact holes CNT2. The driving power transfer wire PW2 may overlap the fan-out wires FW. Accordingly, the driving power input wire PW1 and the driving power transfer wire PW2 may be electrically connected to each other. The driving power connection member PCM1 may overlap the fan-out wire FW.

The plurality of first contact holes CNT1 may be arranged in the direction x. The first contact holes CNT1 may be apart from an edge of the fan-out wire FW by certain distances d1 and d2 in a plan view. The distances d1 and d2 refer to a shortest distance in a plan view from the edge of the fan-out wire FW to an edge of the first contact hole CNT1 and may be about 5 µm or greater. The center distance cd between centers of adjacent first contact holes CNT1 may not be constant.

In the same way, a plurality of second contact holes CNT2 may be arranged in the direction x. The second contact holes CNT2 may be apart from an edge of the fan-out wire FW by certain distances d1 and d2 in a plan view. The distances d1 and d2 refer to a shortest distance in a plan view from the edge of the fan-out wire FW to an edge of the second contact hole CNT2 and may be about 5 µm or greater. The center distance cd between centers of adjacent second contact holes CNT2 may not be constant.

The first contact holes CNT1 and the second contact holes CNT2 may not correspond one-to-one. For example, the number of first contact holes CNT1 and the number of second contact holes CNT2 may be different from each other.

Because the first contact holes CNT1 and the second contact holes CNT2 are arranged not to overlap the edge of the fan-out wire FW, additional contact holes may be formed to decrease electrical resistance.

Various modifications may be made, for example, as shown in FIG. 9, the first contact holes CNT1 may be arranged in two rows, or as shown in FIG. 10, the first contact holes CNT1 and the second contact holes CNT2 may both be arranged in two rows.

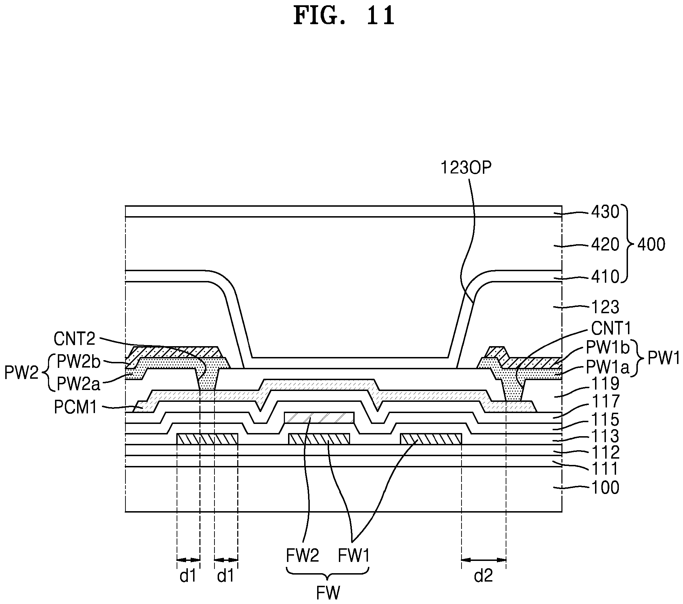

FIG. 11 is a schematic cross-sectional view of a portion of a display apparatus according to an embodiment. More specifically, FIG. 11 shows part of a peripheral area of a display panel. In FIG. 11, elements that are the same as those in FIGS. 4 and 7 are designated by the same reference numerals.

Referring to FIG. 11, the fan-out wires FW, the driving power input wire PW1, the driving power transfer wire PW2, and the driving power connection member PCM1 may be arranged in the peripheral area of the display panel.

The fan-out wire FW may include the first fan-out wire FW1 and the second fan-out wire FW2. The first fan-out wire FW1 over the substrate 100 may be disposed on the first gate insulating layer 112. The second fan-out wire FW2 may be disposed on the second gate insulating layer 113. The second fan-out wire FW2 may overlap the first fan-out wire FW1.

The driving power connection member PCM1 may overlap the fan-out wires FW and may be disposed on the second interlayer insulating layer 117. The driving power connection member PCM1 is a member connecting the driving power input wire PW1 and the driving power transfer wire PW2 to each other and may be connected thereto through the first contact hole CNT1 and the second contact hole CNT2, respectively.

In the present embodiment, the driving power input wire PW1 may include a first conductive layer PW1a and a second conductive layer PW1b. The first conductive layer PW1a may include the same material as that of the first source electrode SE1 (refer to FIG. 4) and the first drain electrode DE1 (refer to FIG. 4). The second conductive layer PW1b may include the same material as that of the second wire WL2.

In the same way, the driving power transfer wire PW2 may include a first conductive layer PW2a and a second conductive layer PW2b. The first conductive layer PW2a may include the same material as that of the first source electrode SE1 (refer to FIG. 4) and the first drain electrode DE1 (refer to FIG. 4). The second conductive layer PW2b may include the same material as that of the second wire WL2.

In this case, the driving power input wire PW1 and the driving power transfer wire PW2 may be covered by the second organic insulating layer 123. The second organic insulating layer 123 may have an opening 123OP in the peripheral area PA and thus may at least partially expose the third interlayer insulating layer 119, which is an inorganic insulating layer. An upper surface of the third interlayer insulating layer 119 exposed by the opening 123OP in the second organic insulating layer 123 may be in direct contact with the first inorganic encapsulation layer 410 of the thin-film encapsulation layer 400. Accordingly, an excellent encapsulation effect may be obtained.

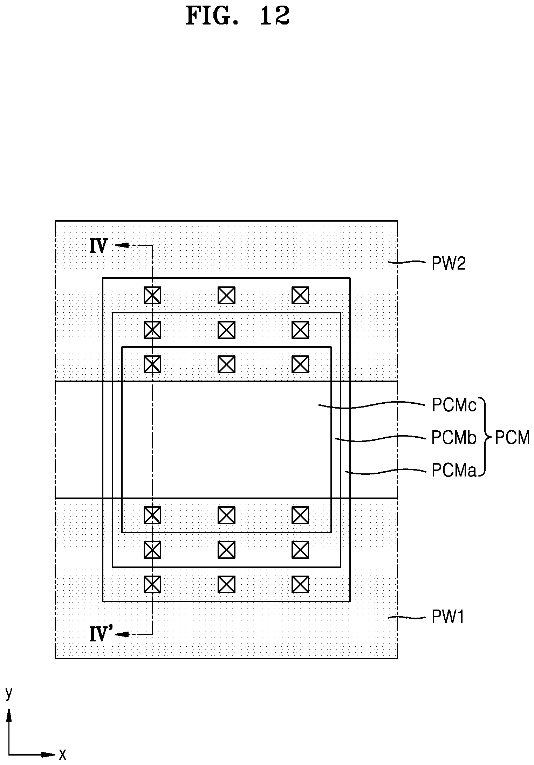

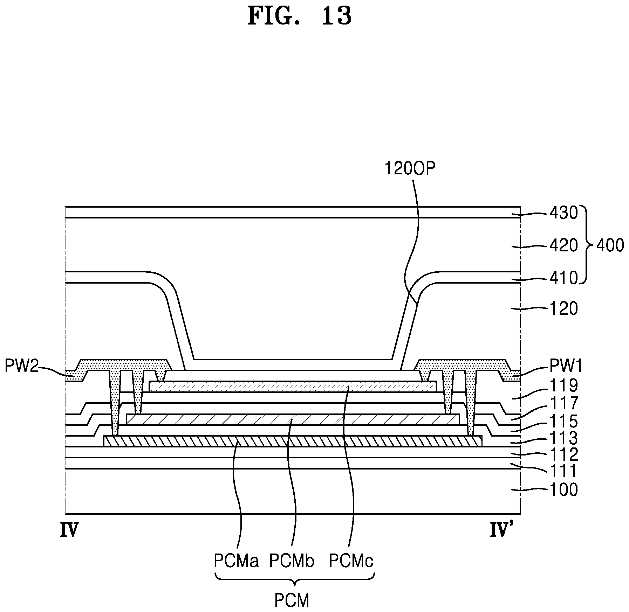

FIG. 12 is an enlarged plan conceptual diagram of a portion of a display apparatus according to embodiments. FIG. 13 is a schematic cross-sectional view of a portion of the display apparatus of FIG. 12, taken along a line IV-IV' of FIG. 12. More specifically, FIGS. 12 and 13 show part of a peripheral area of a display panel. In FIGS. 12 and 13, elements that are the same as those in FIGS. 6 and 7 are designated by the same reference numerals.

Referring to FIGS. 12 and 13, a power input wire PW1, a power transfer wire PW2, and a power connection member PCM may be arranged in the peripheral area of the display panel. The power input wire PW1 and the power transfer wire PW2 may be apart from each other and may be electrically connected to each other by the power connection member PCM arranged in a lower layer. The power input wire PW1 and the power transfer wire PW2 may be disposed on the third interlayer insulating layer 119. The power connection member PCM may be disposed under the third interlayer insulating layer 119.

Because a region where a fan-out wire is not arranged may be present in the peripheral area of the display panel, a region where the power input wire PW1, the power transfer wire PW2, and the power connection member PCM do not overlap a fan-out wire may be present.

In this case, the power connection member PCM may be provided in various layers. For example, the power connection member PCM may include the same layers as the fan-out wires FW (refer to FIG. 7). That is, the power connection member PCM may include a first layer PCMa disposed on the first gate insulating layer 112, which is a layer on which a first gate electrode of a first thin-film transistor is disposed. The first layer PCMa may be connected to the power input wire PW1 and the power transfer wire PW2 through contact holes, respectively.

The power connection member PCM may include a second layer PCMb disposed on the second gate insulating layer 113, which is a layer on which a second electrode of a storage capacitor is disposed. The second layer PCMb may be connected to the power input wire PW1 and the power transfer wire PW2 through contact holes, respectively.

In addition, the power connection member PCM may include a third layer PCMc disposed on the second interlayer insulating layer 117, which is a layer on which a second gate electrode of a second thin-film transistor is disposed. The third layer PCMc may be connected to the power input wire PW1 and the power transfer wire PW2 through contact holes, respectively.

The power connection member PCM may have a structure in which the first layer PCMa, the second layer PCMb, and the third layer PCMc overlap one another. However, one or more embodiments are not limited thereto. The power connection member PCM may include at least one of the first layer PCMa, the second layer PCMb, and the third layer PCMc. That is, the power connection member PCM may have a single-layer or multi-layer structure.

The power input wire PW1 and the power transfer wire PW2 may be configured to transfer the driving voltage VDD (refer to FIG. 3A). In an embodiment, the power input wire PW1 and the power transfer wire PW2 may be configured to transfer the common voltage VSS (refer to FIG. 3A).

The organic insulating layer 120 may cover the power input wire PW1 and the power transfer wire PW2 and may include the opening 120OP exposing a region between the power input wire PW1 and the power transfer wire PW2. The first inorganic encapsulation layer 410 of the thin-film encapsulation layer 400 may be arranged in the opening 120OP to be in direct contact with the third interlayer insulating layer 119, and thus, an excellent encapsulation effect may be obtained.

As described above, according to one or more embodiments, a display apparatus with high reliability in which a high-quality image may be displayed may be provided by properly arranging contact holes in a peripheral area. However, such a technical feature is an example, and the effect of one or more embodiments is not limited thereto.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A display apparatus comprising:
a substrate (100) comprising a display area and a peripheral area around the display area;
a light-emitting element (LED) arranged in the display area and a pixel circuit (PC) configured to drive the light-emitting element;
fan-out wires (FW) electrically connected to the pixel circuit and arranged in the peripheral area;
a power input wire (PW1) and a power transfer wire (PW2) apart from each other in the peripheral area; and
a connection member (PCM1) connected to the power input wire (PW1) through first contact holes (CNT1) and connected to the power transfer wire (PW2) through second contact holes (CNT2),
wherein the connection member (PCM1) at least partially overlaps the fan-out wires, and a center distance between centers of adjacent first contact holes is not constant.

2. The display apparatus of claim 1, wherein a center distance between centers of adjacent second contact holes is not constant.

3. The display apparatus of claim 1 or 2, wherein the first contact holes comprise 1st-1 contact holes (CNT1-1) overlapping the fan-out wires and 1st-2 contact holes (CNT1-2) not overlapping the fan-out wires (FW),
wherein a center distance (cd1) between the 1st-1 contact holes (CNT1-1) and the 1st-2 contact holes (CNT1-2) that are adjacent to each other with an edge of the fan-out wires (FW) therebetween is greater than a center distance (cd2) between two adjacent 1st-1 contact holes (CNT1-1) that are disposed adjacent to the edge of the fan-out wires.

4. The display apparatus of any of the preceding claims, wherein the number of the first contact holes (CNT1) and the number of the second contact holes (CNT2) are different from each other.

5. The display apparatus of any of the preceding claims, wherein the first contact holes (CNT1) comprise a 1st-1 contact hole (CNT1-1) overlapping the fan-out wires (FW),
wherein the 1st-1 contact hole (CNT1-1) is separated from edges of the fan-out wires (FW) in a plan view.

6. The display apparatus of claim 5, wherein a distance by which the 1st-1 contact hole (CNT1-1) is separated from edges of the fan-out wires (FW) is at least 5 µm.

7. The display apparatus of any of the preceding claims, wherein the pixel circuit (PC) comprises:
a first thin-film transistor (TFT1) comprising a first semiconductor layer (AS1) and a first gate electrode (GE1); and
a second thin-film transistor (TFT2) comprising a second semiconductor layer (AO2) and a second gate electrode (GE2),
wherein the first semiconductor layer is arranged on a layer different from a layer on which the second semiconductor layer is arranged.

8. The display apparatus of claim 7, wherein at least some of the fan-out wires (FW) are arranged on a same layer on which the first gate electrode (GE1) is arranged.

9. The display apparatus of claim 7 or 8, wherein the connection member (PCM1) is arranged on a same layer on which the second gate electrode (GE2) is arranged.

10. The display apparatus of any of the preceding claims, further comprising an organic insulating layer (120) arranged on the power input wire and the power transfer wire,
wherein the organic insulating layer (120) comprises an opening (120OP, 123OP) above at least a portion of the connection member.

11. The display apparatus of any of the preceding claims, wherein the first contact holes (CNT1) are arranged in two rows in a first direction.

12. The display apparatus of any of the preceding claims, wherein the second contact holes (CNT2) are arranged in two rows in a first direction.

13. The display apparatus of any of the preceding claims, wherein the power input wire comprises a first conductive layer and a second conductive layer stacked on each other.

14. The display apparatus of any of the preceding claims, further comprising:
a thin-film encapsulation layer (400) covering the light-emitting element and comprising a first inorganic encapsulation layer (410), an organic encapsulation layer (420), and a second inorganic encapsulation layer (430); and
an interlayer insulating layer covering the connection member and having first contact holes and second contact holes defined therein.

15. The display apparatus of claim 14, wherein a first inorganic encapsulation layer (410) is arranged in the opening (120OP, 123OP) of the organic insulating layer (120) and is in direct contact with the interlayer insulating layer.
